(19) Europäisches Patentamt
European Patent Office
Office européen des brevets

(11) EP 4 198 535 A1

(12) DEMANDE DE BREVET EUROPEEN

(43) Date de publication:
**21.06.2023 Bulletin 2023/25**

(21) Numéro de dépôt: **22212878.7**

(22) Date de dépôt: **12.12.2022**

(51) Classification Internationale des Brevets (IPC):
***G01R 31/367*** ***(2019.01)*** ***G01R 31/379*** ***(2019.01)***
***G01R 31/387*** ***(2019.01)*** ***G01R 31/382*** ***(2019.01)***

(52) Classification Coopérative des Brevets (CPC):
**G01R 31/379; G01R 31/367; G01R 31/382; G01R 31/387**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**KH MA MD TN**

(30) Priorité: **20.12.2021 FR 2114045**

(71) Demandeurs:
- **Commissariat à l'énergie atomique et aux énergies alternatives 75015 Paris (FR)**
- **Centre National de la Recherche Scientifique 75016 Paris (FR)**
- **Université Savoie Mont Blanc 73011 Chambéry Cedex (FR)**

(72) Inventeurs:
- **CUGNET, Mikael 38054 GRENOBLE Cedex 09 (FR)**
- **DUTYKH, Denys 73000 CHAMBERY (FR)**
- **GALLOIS, Florian 38054 GRENOBLE Cedex 09 (FR)**
- **KIRCHEV, Angel Zhivkov 38054 GRENOBLE Cedex 09 (FR)**

(74) Mandataire: **Cabinet Nony 11 rue Saint-Georges 75009 Paris (FR)**

# (54) PROCÉDÉ D'ESTIMATION DE L'ÉTAT DE CHARGE D'UNE BATTERIE AU PLOMB EN SITUATION D'AUTODÉCHARGE

(57) Procédé d'estimation de l'état de charge d'une batterie au plomb en situation d'autodécharge Procédé d'estimation de l'état de charge d'une batterie rechargeable au plomb électriquement au repos, la batterie comportant au moins une cellule électrochimique comportant un électrolyte acide, au moins une électrode négative en plomb et au moins une électrode positive en dioxyde de plomb immergées dans l'électrolyte, le procédé comportant la mise en œuvre d'un modèle prédictif régi au moins par plusieurs équations différentielles pour estimer l'état de charge.

[Fig 8]

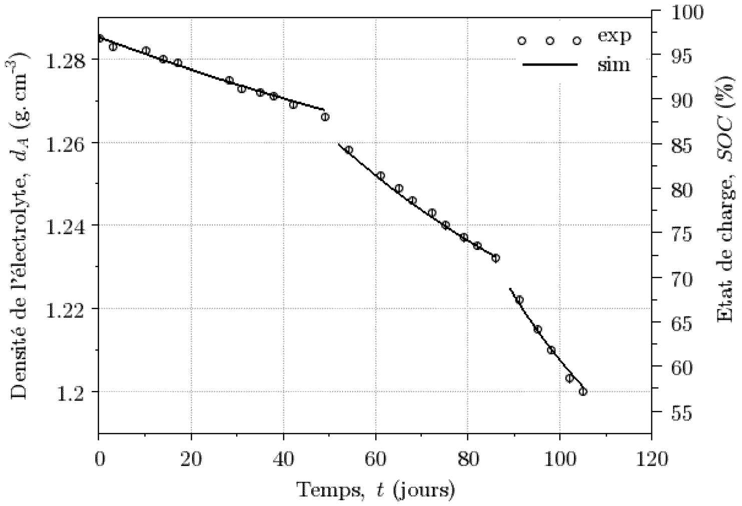


EP 4 198 535 A1

## Description

La présente invention concerne la prévision et la gestion de l'état de charge d'une batterie rechargeable au plomb ou d'un ensemble de telles batteries reliées électriquement entre elles en situation d'autodécharge.

Les batteries rechargeables au plomb sont souvent utilisées comme source d'alimentation électrique de secours dans des installations pour pallier des pannes d'alimentation en courant électrique qui peuvent survenir et avoir des conséquences préjudiciables, comme c'est par exemple le cas dans les hôpitaux.

Les batteries plomb-acide sont souvent choisies pour cette application en raison de leur robustesse et de leur faible coût d'exploitation qui est lié au fait que l'alimentation électrique de l'installation au moyen des batteries est rarement mise en oeuvre.

Pour maintenir une batterie opérationnelle et prête à prendre le relais en cas d'une panne de courant électrique, la méthode de gestion connue consiste à maintenir la batterie en mode de veille, dans un état complètement chargé. Cette procédure, généralement appelée « charge de maintien », ou « floating charge » en anglais, consiste à appliquer en permanence une surcharge contrôlée par la tension électrique, destinée à compenser les processus d'autodécharge, qui sont à l'origine de l'usure de la batterie. Les processus d'autodécharge peuvent être exprimés au moyen de la réaction suivante à l'électrode négative

[Chem 1]

$$Pb + H_2SO_4 \rightleftharpoons PbSO_4 + 2\,H^+ + 2\,e^-$$

et de la réaction suivante à l'électrode positive

[Chem 2]

$$PbO_2 + H_2SO_4 + 2\,H^+ + 2\,e^- \rightleftharpoons PbSO_4 + 2\,H_2O$$

L'excès de charge résiduel résultant de la compensation des processus d'autodécharge conduit au développement des réactions électrochimiques parasites suivantes

[Chem 3]

$$2\,H^+ + 2\,e^- \rightleftharpoons H_2$$

$$H_2O \rightleftharpoons \frac{1}{2}\,O_2 + 2\,H^+ + 2\,e^-$$

qui produisent un dégagement d'hydrogène à l'électrode négative et d'oxygène à l'électrode positive.

Il est en outre connu que l'autodécharge d'une batterie est accélérée sous l'effet de l'agitation thermique, comme documenté par exemple dans RU 2138886 C1. Ainsi, la pièce dans lesquelles sont stockées les batteries est généralement régulée en température pour réduire la perte de charge électrique.

Cependant, la méthode de gestion présentée ci-dessus présente plusieurs inconvénients. Tout d'abord, le maintien d'une batterie à son état de charge électrique maximal est énergétiquement coûteux. De plus, cette méthode de gestion réduit la durée de vie de la batterie, comme cela a été décrit dans JP H08-50925, qui doit être remplacée régulièrement afin d'assurer la continuité de l'alimentation électrique de l'installation en cas de coupure du réseau électrique.

Par ailleurs, en pratique, la détermination de l'état de charge d'une batterie est difficile à mesurer, d'autant plus lorsque la batterie est fermée et que les organes internes qui la composent sont inaccessibles. En particulier, une simple mesure de la tension électrique entre les cosses de la batterie ne permet que de déterminer la variation de potentiel électrique entre les deux électrodes, et pas le potentiel de l'électrode négative ni le potentiel de l'électrode positive qui sont nécessaires à la détermination de l'état de charge.

RU 2218635 C2 s'est intéressé à la modélisation de la charge d'une batterie étanche en vue de minimiser la génération de gaz. US 10,036,779 B2 décrit un procédé pour déterminer des courants d'autodécharge dans une batterie

ainsi que pour détecter des courts circuits.

Il existe donc un besoin pour s'affranchir des inconvénients précités.

L'invention propose un procédé d'estimation de l'état de charge d'une batterie rechargeable au plomb électriquement au repos, la batterie comportant au moins une cellule électrochimique comportant un électrolyte acide, au moins une électrode négative en plomb et au moins une électrode positive en dioxyde de plomb immergées dans l'électrolyte, le procédé comportant la mise en oeuvre d'un modèle prédictif régi au moins par des équations différentielles pour estimer l'état de charge.

Comme cela sera visible plus en détail par la suite, l'invention permet d'estimer avec précision l'état de charge de la batterie, notamment en déterminant l'évolution du potentiel électrique de chaque électrode, et optionnellement de la masse volumique de l'électrolyte. L'invention permet avantageusement, pour un exploitant d'un équipement de batteries de secours, de procéder à une charge de maintenance des batteries seulement lorsque cela s'avère nécessaire, et ainsi d'éviter d'avoir à maintenir en permanence les batteries pleinement chargées.

Une batterie « électriquement au repos » est telle qu'aucun courant électrique n'est conduit par ses cosses, notamment au travers d'un circuit électrique reliant la batterie à un ou plusieurs organes électriques externes. Une batterie dont les cosses sont en contact avec des connecteurs électriques au sein d'un circuit électrique ouvert est électriquement au repos. Une batterie dont les cosses sont à distance de tels connecteurs électriques est aussi électriquement au repos. Autrement dit, une batterie électriquement au repos est en situation d'autodécharge. A l'inverse, une batterie qui alimente électriquement une installation électrique ou une batterie qui est chargée au moyen d'un générateur électrique n'est pas électriquement au repos.

De préférence, la batterie au plomb est de type étanche. La mise en oeuvre du procédé pour une batterie de type étanche est particulièrement avantageuse, car les organes de ce type de batterie sont difficilement accessibles, voire inaccessibles, sans endommager la batterie. De préférence, l'électrolyte comporte, voire consiste en, un solvant aqueux, de préférence de l'eau, et de l'acide sulfurique en solution dans le solvant aqueux.

De préférence, les équations différentielles sont des équations différentielles ordinaires, en particulier du premier ordre. Le modèle prédictif permet ainsi de tenir compte simplement de l'évolution temporelle de fonctions caractérisant l'état de la batterie.

De préférence, les équations différentielles sont couplées les unes aux autres. Autrement dit, les équations différentielles forment un système d'équations et ne peuvent pas être résolues séparément.

De préférence, le modèle prédictif dépend de la température de l'électrolyte. Le modèle fournit ainsi une meilleure prédiction de l'évolution de l'état de charge de la batterie en fonction de la température. Avantageusement, cela permet à un exploitant d'un équipement de batteries de secours, de réguler au mieux la température de la pièce dans laquelle sont stockées les batteries, ou en l'absence de régulation, d'anticiper la recharge électrique des batteries en fonction de la température au sein de l'équipement.

De préférence, le procédé comporte la détermination préalable des paramètres initiaux du modèle prédictif au moyen d'une batterie au plomb test qui est identique à la batterie au plomb dont l'état de charge est à estimer. Avantageusement, le procédé peut ainsi être mis en œuvre pour une grande variété de batteries au plomb, de volume et/ou de références commerciales différents. Par « identique », on entend que la batterie test et la batterie dont l'état de charge est à estimer sont formées des mêmes organes, notamment des électrodes négative et positive et électrolyte, et présentent des caractéristiques identiques lors de leur première charge électrique complète.

De préférence, le modèle prédictif est configuré pour fournir une estimation de chacun des états de charge de l'au moins une électrode positive et de l'au moins une électrode négative.

De préférence, l'état de charge de la batterie est la plus petite valeur entre l'état de charge de l'électrode négative et l'état de charge de l'électrode positive.

De préférence, l'état de charge de l'électrode négative est égal au rapport de la capacité électrique de l'électrode négative sur la capacité électrique à charge maximale de l'électrode négative, et l'état de charge de l'électrode positive est égal au rapport de la capacité électrique de l'électrode positive sur la capacité électrique à charge maximale de l'électrode positive.

Dans une variante de mise en oeuvre du procédé, la batterie comporte plusieurs cellules électrochimiques, et l'état de charge de la batterie est de préférence la plus petite valeur entre le plus petit état de charge parmi l'ensemble des électrodes négatives de la batterie et le plus petit état de charge parmi l'ensemble des électrodes positives de la batterie.

De préférence, le modèle prédictif est numérique, *i.e.* les équations différentielles sont résolues numériquement au moyen d'un ordinateur. Autrement dit, le procédé d'estimation de l'état de charge est mis en oeuvre par ordinateur.

De préférence, le modèle prédictif est régi par :

- au moins une équation différentielle relative à l'électrode négative, qui détermine l'évolution temporelle d'au moins une grandeur physique caractéristique de l'état électrochimique de l'électrode négative,
- au moins une équation différentielle relative à l'électrode positive, qui détermine l'évolution temporelle d'au moins

une grandeur physique caractéristique de l'état électrochimique de l'électrode positive, et

- au moins une équation différentielle relative à l'électrolyte, qui détermine l'évolution temporelle d'au moins une grandeur physique caractéristique de l'état électrochimique de l'électrolyte.

La grandeur physique caractéristique de l'état électrochimique de l'électrode négative permet d'estimer directement ou indirectement l'état de charge de l'électrode négative. De préférence, elle est choisie parmi le potentiel électrique de l'électrode négative, la capacité électrique de l'électrode négative, la masse de sulfate de plomb électrodéposée à la surface de l'électrode négative et la masse de plomb résiduelle à l'électrode négative.

La grandeur physique caractéristique de l'état électrochimique de l'électrode positive permet d'estimer directement ou indirectement l'état de charge de l'électrode positive. De préférence, elle est choisie parmi le potentiel électrique de l'électrode positive, la capacité électrique de l'électrode positive, la masse de sulfate de plomb électrodéposée à la surface de l'électrode positive et la masse de dioxyde de plomb résiduelle à l'électrode positive.

La grandeur physique caractéristique de l'état électrochimique de l'électrolyte permet d'estimer directement ou indirectement les proportions ou quantités d'eau et d'acide respectivement contenues dans l'électrolyte. De préférence, elle est choisie parmi le nombre de moles d'eau de l'électrolyte, le nombre de moles d'acide sulfurique de l'électrolyte, la densité de l'électrolyte, la molalité de l'électrolyte et la molarité de l'électrolyte.

De préférence, la ou les équations différentielles d'électrode relatives à l'électrode négative, la ou les équations différentielles d'électrode relatives à l'électrode positive et la ou les équations différentielles d'électrolyte relatives à l'électrolyte sont couplées les unes aux autres. Ainsi, le modèle tient compte d'une façon particulièrement réaliste des réactions ayant lieu à l'électrode négative, à l'électrode positive et au sein de l'électrolyte et qui influent sur l'état de charge de l'électrode négative et sur l'état de charge de l'électrode positive.

De préférence, le modèle est régi au moins par au moins deux équations différentielles relatives à l'électrode négative, deux équations différentielles relatives à l'électrode positive, et deux équations différentielles relatives à l'électrolyte.

De préférence, le modèle prédictif est régi au moins par :

- au moins une équation différentielle déterminant l'évolution temporelle du potentiel électrique $u_{neg}$ de l'électrode négative et une équation différentielle déterminant l'évolution temporelle de la charge électrique $Q_{neg}$ de l'électrode négative,
- au moins une équation différentielle déterminant l'évolution temporelle du potentiel électrique $u_{pos}$ de l'électrode positive et une équation différentielle déterminant l'évolution temporelle de la charge électrique $Q_{pos}$ de l'électrode positive,
- au moins une équation différentielle déterminant l'évolution temporelle du nombre de moles d'eau dans l'électrolyte et une équation différentielle déterminant l'évolution temporelle du nombre de moles d'acide sulfurique dans l'électrolyte.

De préférence, le modèle prédictif électrochimique est régi par les équations différentielles (1) à (6) suivantes, assorties des relations (7) à (13) :

[Math 1]

$$\begin{cases} \dot{u}_{\mathrm{neg}} = -\dfrac{i_{\mathrm{Pb}}}{C_{\mathrm{dc,neg}}} - \dfrac{i_{\mathrm{H_2}}}{C_{\mathrm{dc,neg}}} & (1) \\ \dot{u}_{\mathrm{pos}} = -\dfrac{i_{\mathrm{PbO_2}}}{C_{\mathrm{dc,pos}}} - \dfrac{i_{\mathrm{O_2}}}{C_{\mathrm{dc,pos}}} & (2) \\ \dot{Q}_{\mathrm{neg}} = -\mathcal{A}_{\mathrm{neg}}\, i_{\mathrm{Pb}} & (3) \\ \dot{Q}_{\mathrm{pos}} = \mathcal{A}_{\mathrm{pos}}\, i_{\mathrm{PbO_2}} & (4) \\ \dot{n}_0 = -\dfrac{\mathcal{A}_{\mathrm{pos}}}{F}\, i_{\mathrm{PbO_2}} - \dfrac{\mathcal{A}_{\mathrm{pos}}}{2\,F}\, i_{\mathrm{O_2}} & (5) \\ \dot{n}_{\mathrm{A}} = \dfrac{\mathcal{A}_{\mathrm{pos}}}{2\,F}\, i_{\mathrm{PbO_2}} - \dfrac{\mathcal{A}_{\mathrm{neg}}}{2\,F}\, i_{\mathrm{Pb}} & (6) \end{cases}$$

dans lesquelles

- $u_{neg}$, $Q_{neg}$ et $A_{neg}$ sont respectivement le potentiel électrique, la capacité électrique et l'aire de la surface électroactive de l'électrode négative de la batterie,
- $u_{pos}$ et $Q_{pos}$ et $A_{pos}$ sont respectivement le potentiel électrique, la capacité électrique et l'aire de la surface électroactive de l'électrode positive de la batterie,
- $C_{dc,neg}$ et $C_{dc,pos}$ sont les capacitances de double couche constantes associées à l'électrode négative et l'électrode positive respectivement, qui peuvent être soit déterminées expérimentalement, soit issues de la littérature, par exemple de W. Tiedemann and J. Newman, « Double-Layer Capacity Determination of Porous Electrodes », J. Electrochem. Soc. 122 (1975) 70, https://robots.iopscience.iop.org/article/10.1149/1.2134161/meta.

- $F$ est la constante de Faraday égale à 96 485 C.mol$^{-1}$,
- $n_O$ et $n_A$ sont les moles d'eau et d'acide sulfurique respectivement,
- $i_{Pb}$ est l'intensité du courant électrique associée à la réaction électrochimique suivante

[Chem 4]

$$\mathrm{Pb} + \mathrm{H_2SO_4} \rightleftharpoons \mathrm{PbSO_4} + 2\,\mathrm{H^+} + 2\,\mathrm{e^-}$$

- $i_{H2}$ est l'intensité du courant électrique associée à la réaction électrochimique suivante

[Chem 5]

$$2\,\mathrm{H^+} + 2\,\mathrm{e^-} \rightleftharpoons \mathrm{H_2}$$

- $i_{O2}$ est l'intensité du courant électrique associée à la réaction électrochimique suivante

[Chem 6]

$$H_2O \rightleftharpoons \frac{1}{2} O_2 + 2\,H^+ + 2\,e^-$$

- $i_{PbO2}$ est l'intensité du courant électrique associée à la réaction électrochimique suivante

[Chem 7]

$$PbO_2 + H_2SO_4 + 2\,H^+ + 2\,e^- \rightleftharpoons PbSO_4 + 2\,H_2O$$

les densités surfaciques de courant $i_k$, avec $k$ étant l'un quelconque des réactions électrochimiques d'indice $O_2$, $H_2$, Pb et $PbO_2$, étant exprimées selon l'équation 7, dite de Butler-Volmer, et étant telles que
[Math 2]

$$i_k = i_{0,k} \left\{ \exp\left[ (1-\alpha_k) \frac{n_k\, F\, \eta_k}{R T^\circ} \right] - \exp\left[ -\alpha_k \frac{n_k\, F\, \eta_k}{R T^\circ} \right] \right\} \qquad (7)$$

avec

- $R$ étant la constante des gaz parfaits égale à 8,3144621 $J.K^{-1}.mol^{-1}$,
- $n_k$ étant le nombre d'électrons transférés au cours de la réaction ($n_k = 2$),
- $T°$ étant une température de référence, de préférence comprise entre 293 K et 298 K,
- $\alpha_k$ étant le facteur de symétrie de la réaction correspondante, qui peut être déterminé expérimentalement au moyen de la pente de la droite de Tafel qui relie la surtension $\eta_k$ de l'électrode au logarithme de la densité de courant $i_k$ appliquée à l'électrode,
- $\eta_k$ est la surtension de l'électrode et est exprimée selon l'équation (8)
[Math 3]

$$\eta_k = u_j - u_k^0 \qquad (8)$$

le potentiel d'équilibre $u_k^0$ étant exprimé selon l'équation (9)
[Math 4]

$$u_k^0 = \frac{\Delta \bar{G}_k^0\,(T^\circ)}{n_k\, F} - (T - T^\circ)\, \frac{\Delta \bar{S}_k^0\,(T^\circ)}{n_k\, F} - (T - T^\circ)^2\, \frac{\Delta \bar{C}_{p,k}^0\,(T^\circ)}{2\, n_k\, F\, T} \qquad (9)$$

avec

- T étant la température de l'électrolyte,
- $\Delta \bar{G}_k^0, \Delta \bar{S}_k^0$ et $\Delta \bar{C}_{p,k}^0$ étant respectivement l'énergie libre de Gibbs molaire, l'entropie molaire et la capacité calorifique molaire de la réaction $k$ parmi $O_2$, H2, Pb et $PbO_2$, déterminés à partir de la molalité $m_A$ qui est définie selon l'équation (10) comme
[Math 4]

$$m_A = 55.5\, \frac{n_A}{n_0} \qquad (10)$$

L'énergie libre de Gibbs molaire $\bar{G}_k^0$ , l'entropie molaire $\Delta\bar{S}_k^0$ et la capacité calorifique molaire $\Delta\bar{C}_{p,k}^0$ sont connues pour les réactions mentionnées et sont par exemple référencées dans D. D. Wagman, W. H. Evans, V. B. Parker, R. H. Schumm, I. Halow, S. M. Bailey, K. L. Churney, and R. L. Nuttall, "The NBS Tables of Chemical Thermodynamic Properties" J. Phys. Chem. Ref. Data, vol. 11, no. Suppl. 2, 1982.
La densité de courant d'échange $i_{0,k}$ est définie par l'équation (11)
[Math 5]

$$i_{0,k} = n_k F \left(\prod_i a_{i,O}^{s_{i,O}}\right)^{1-\alpha_k} \left(\prod_j a_{j,R}^{s_{j,R}}\right)^{\alpha_k} k_{0,k} \exp\left(-\frac{\Delta\bar{G}_{\ddagger,k}}{RT}\right) \quad (11)$$

dans laquelle
- $a_i$ est l'activité de chaque espèce $i$ impliquée dans la réaction $k$ issue des tables disponibles dans la section 2.3 du livre de H. Bode, « Lead-Acid Batteries ». New York, NY: John Wiley & Sons, Inc., 1977,
- $k_{0,k}$ est la constante cinétique de la réaction électrochimique $k$,
- $\Delta\bar{G}_{\ddagger,k}$ est l'énergie libre de Gibbs molaire de l'état de transition.

La tension globale de la batterie $u_{batt}$ est exprimée par l'équation (12),
[Math 6]

$$u_{\text{batt}} = N_{\text{cell}}\, u_{\text{cell}} = N_{\text{cell}} \left(u_{\text{pos}} - u_{\text{neg}}\right) \quad (12)$$

$N_{cell} \geq 1$ étant le nombre de cellules électrochimiques connectées électriquement en série de la batterie, l'état de charge de la batterie $SOC_{batt}$ étant la plus faible valeur entre l'état de charge de l'électrode négative $SOC_{neg}$ et l'état de charge de l'électrode positive $SOC_{pos}$, selon l'équation (13)
[Math 7]

$$SOC_{\text{batt}} = \min\left(SOC_{\text{pos}}, SOC_{\text{neg}}\right) = \min\left(\frac{Q_{\text{pos}}}{Q_{\text{pos,max}}}, \frac{Q_{\text{neg}}}{Q_{\text{neg,max}}}\right) \quad (13)$$

$Q_{neg,max}$ étant la capacité maximale de l'électrode négative, $Q_{pos,max}$ étant la capacité maximale de l'électrode positive.

L'invention concerne encore une méthode de gestion de la charge d'au moins une batterie rechargeable au plomb électriquement au repos, la méthode comportant la mise en oeuvre du procédé selon l'invention pour déterminer l'état de charge de la batterie au plomb, et lorsque l'état de charge de la batterie au plomb est inférieur ou égal à une valeur minimale d'état de charge, l'alimentation électrique de la batterie pour en augmenter l'état de charge.
La valeur minimale d'état de charge est 0 %, ce qui signifie que la batterie est totalement déchargée. La valeur maximale d'état de charge est 100 %, ce qui signifie que la batterie est totalement chargée.
De préférence, la batterie est un organe d'un équipement d'alimentation électrique de secours d'une installation choisie parmi un centre de données, ou « data center » en anglais, un hôpital, une centrale nucléaire et un central téléphonique et/ou internet.
Notamment, la méthode peut être avantageusement mise en œuvre dans une pièce dont la température est non régulée, en particulier dans la variante où le modèle prédictif est dépendant de la température de l'électrolyte.
L'invention pourra être mieux comprise à la lecture des exemples de mise en oeuvre du procédé qui vont suivre, et du dessin annexé dans lequel :

[Fig. 1a] et [Fig. 1b] sont des graphiques représentant l'évolution du potentiel de l'électrode positive en dioxyde de plomb et du potentiel de l'électrode négative en plomb respectivement en fonction du temps pour une durée d'autodécharge de 49 jours à une température de 25 °C,
[Fig. 2] est un graphique représentant l'évolution de la masse volumique de l'électrolyte mesurée et simulée au

moyen du modèle prédictif (ordonnée de gauche) et l'évolution de l'état de charge de la batterie (ordonnée de droite) en fonction du temps pour une durée d'autodécharge de 49 jours à une température de 25 °C,

[Fig. 3a] et [Fig. 3b] sont des graphiques représentant l'évolution du potentiel de l'électrode positive en dioxyde de plomb et du potentiel de l'électrode négative en plomb respectivement en fonction du temps pour une durée d'autodécharge de 34 jours à une température de 35 °C,

[Fig. 4] est un graphique représentant l'évolution de la masse volumique de l'électrolyte mesurée et simulée au moyen du modèle prédictif (ordonnée de gauche) et l'évolution de l'état de charge de la batterie (ordonnée de droite) en fonction du temps pour une durée d'autodécharge de 34 jours à une température de 35 °C,

[Fig. 5a] et [Fig. 5b] sont des graphiques représentant l'évolution du potentiel de l'électrode positive en dioxyde de plomb et du potentiel de l'électrode négative en plomb respectivement en fonction du temps pour une durée d'autodécharge de 16 jours à une température de 45 °C,

[Fig. 6] est un graphique représentant l'évolution de la masse volumique de l'électrolyte mesurée et simulée au moyen du modèle prédictif (ordonnée de gauche) et l'évolution de l'état de charge de la batterie (ordonnée de droite) en fonction du temps pour une durée d'autodécharge de 16 jours à une température de 45 °C,

[Fig. 7a] et [Fig. 7b] sont des graphiques qui représentent l'évolution du potentiel de l'électrode positive en dioxyde de plomb et du potentiel de l'électrode négative en plomb respectivement en fonction du temps pour l'ensemble des durées et températures de maintien du bain illustrées sur les figures la, 1b, 3a, 3b et 5a, 5b, et

[Fig. 8] est un graphique représentant l'évolution de la masse volumique de l'électrolyte mesurée et simulée au moyen du modèle prédictif (ordonnée de gauche) et l'évolution de l'état de charge au (ordonnée de droite) en fonction du temps pour l'ensemble des durées et températures de maintien du bain illustrées sur les figures 2, 4 et 6.

Exemple

Un exemple de mise en oeuvre du procédé selon l'invention est présenté ci-après. La détermination des paramètres initiaux du modèle prédictif présenté au moyen des équations (1) à (13) a été effectuée au moyen d'une batterie rechargeable au plomb test de technologie « ouverte », commercialisée par la société Trojan sous la référence T-105. Cette batterie test présente une tension électrique de 6 V et une capacité disponible de 185 Ah pour une décharge en 5 h.

Les résultats de la simulation ont ensuite été comparés à des mesures effectuées sur une batterie identique dans les mêmes conditions d'autodécharge que celles qui sont simulées.

Pour déterminer les paramètres initiaux du modèle prédictif, l'enveloppe de la cellule électrochimique centrale de la batterie test a été percée pour en évacuer l'électrolyte. Le volume initial de l'électrolyte ainsi que les concentrations initiales d'eau $\mathring{n}_O$ et d'acide $\mathring{n}_A$ ont été mesurées.

Les capacités électriques initiales $Q_{neg}°$ et $Q_{pos}°$ ainsi que les potentiels électriques initiaux $u_{neg}°$ et $u_{pos}°$ ont été mesurés sur la batterie test. Dans une cellule électrochimique, il n'est pas possible de mesurer directement les potentiels respectifs des électrodes positives d'une part et négatives d'autre part. Une électrode de référence argent-sulfate d'argent ($Ag/Ag_2SO_4$) a donc été introduite dans l'une des cellules électrochimiques de la batterie, qui a permis de mesurer une tension supplémentaire et ainsi de séparer les contributions respectives de chaque électrode à la tension électrique totale de la cellule. Plusieurs cycles de charge/décharge de la cellule ont été effectués afin d'identifier la capacité effectivement disponible et cette valeur a été appliquée comme condition initiale de la capacité électrique des deux électrodes positives et négatives.

La batterie test a ensuite été découpée de manière à en extraire les séparateurs ainsi que les électrodes négatives et les électrodes positives imbibées d'électrolyte.

Avant et après séchage, les masse, longueur, largeur et épaisseur des électrodes négatives et des électrodes positives ont été mesurées, afin de déterminer leurs aires de surface $A_{neg}$ et $A_{pos}$ respectives, au moyen des valeurs de surface spécifique disponibles à la page 303 du livre de H. Bode, « Lead-Acid Batteries ». New York, NY: John Wiley & Sons, Inc., 1977. Alternativement, les aires de surface de l'électrode négative $A_{neg}$ et de l'électrode positive $A_{pos}$ peuvent être déterminées expérimentalement par une mesure de physisorption exploitant la théorie de Brunauer, Emmett et Teller, aussi connu sous le nom de méthode BET.

Une des cellules électrochimiques de la batterie a subi un test de surcharge, ce qui a permis de déterminer notamment les facteurs de symétries $\alpha_k$ au moyen de la loi de Tafel.

Par ailleurs, une autre cellule de la batterie test a été placée dans un bain d'eau à une température de 25 °C et y a été maintenue électriquement au repos pendant une durée de 49 jours. Puis, la température du bain a été augmentée à 35 °C pendant 34 jours supplémentaire, puis augmentée à 45 °C pendant 16 jours additionnels. Les potentiels électriques de chaque électrode ont été mesurés et enregistrés automatiquement chaque jour. Une portion de l'électrolyte située au-dessus des électrodes dans la cellule a été prélevée régulièrement deux fois par semaines et sa masse volumique a été mesurée par densitométrie.

Les paramètres $k_{0,k}$ and $\Delta\overline{G}_{\ddagger,k}$ de chaque réaction électrochimique ont été déterminés par identification, en minimisant l'écart entre les potentiels électriques respectifs de chaque électrode simulés par le modèle prédictif et ceux mesurés sur la batterie test, ainsi que l'écart entre la densité d'électrolyte simulée par le modèle prédictif et celle mesurée sur la batterie test.

Simulation du potentiel électrique des électrodes négative et positive et de l'état de charge de la batterie à 25 °C.

Comme cela est observé sur les figures la et 1b, le modèle reproduit avec précision l'évolution du potentiel électrique de l'électrode positive et de l'électrode négative respectivement.
Il est notamment observé que le potentiel de l'électrode positive a diminué plus rapidement que celui de l'électrode négative. Le potentiel électrique de l'électrode positive a chuté de 20 mV au cours de la durée de l'essai, soit d'environ 0,41 mV par jour, presque sept fois plus vite que le potentiel électrique de l'électrode négative qui a diminué de 3 mV durant la même période, soit d'environ 0,06 mV par jour.
L'évolution sensiblement linéaire des potentiels électriques de l'électrode négative et de l'électrode positive indique donc que l'état de charge de la batterie décroît aussi sensiblement linéairement avec le temps.
Une confirmation de la prévision d'une évolution linéaire de l'état de charge est illustrée sur la figure 2.
La figure 2 représente l'évolution de la masse volumique de l'électrolyte en fonction du temps. Une marge d'erreur de 1 mg.cm$^{-3}$ a été associée aux points de mesure.
L'évolution de la masse volumique obtenue par le modèle prédictif est représentée par la courbe en trait plein. Elle est calculée à partir de la molalité $m_A$ qui est définie selon l'équation (10) et de la température de la batterie $T$ selon l'équation (14) :
[Math 8]

$$d_{\mathrm{A}} = \left(-2.17\, m_{\mathrm{A}}^{2} + 61.1\, m_{\mathrm{A}} + 1\,007\right)\left[1 - 5.7 \times 10^{-4}\,(T - 273)\right] \qquad (14)$$

Le modèle reproduit fidèlement l'évolution de la masse volumique de l'électrolyte. Il est observé une légère déviation de la masse volumique simulée par rapport à la mesure. Bien que non liés par une quelconque théorie, les inventeurs attribuent cette déviation à la stratification de l'acide sulfurique au sein de l'électrolyte. Les molécules d'acide sulfurique tendent à occuper le fond de la cellule électrochimique en raison de leur densité supérieure à celles de l'eau qui les entourent. La mesure de masse volumique est effectuée sur un échantillon prélevé dans la partie supérieure de la cellule, due à l'inaccessibilité des parties inférieures de la cellule, qui est moins dense que l'électrolyte au fond de la cellule. Ceci pourrait expliquer la déviation observée avec la masse volumique obtenue par simulation au moyen du modèle prédictif, qui fournit une valeur moyenne ne tenant pas compte de la position de l'électrolyte dans la cellule.

Simulation du potentiel électrique des électrodes négative et positive et de l'état de charge d'une la batterie à 35 °C.

Suite au maintien au repos de la cellule pendant 49 jours, la température du bain a été augmentée à 35 °C puis maintenue à cette température pendant 34 jours.
Comme cela est observé sur les figures 3a et 3b, le modèle prédictif reproduit fidèlement l'évolution du potentiel électrique de chacune des électrodes négative et positive.
De plus, la vitesse de décroissance du potentiel électrique de l'électrode positive est, comme à 25 °C, environ quatre fois plus rapide que celle du potentiel électrique de l'électrode négative.
Le potentiel électrique de l'électrode positive décroît de 21 mV en trente-quatre jours, soit d'environ 0,62 mV par jour, ce qui est environ 1,5 fois plus rapide qu'à 25 °C. De manière similaire, le potentiel électrique de l'électrode négative décroit de 5 mV en 34 jours, soit d'environ 0,15 mV par jour, ce qui est environ 2,5 fois plus rapide qu'à 25 °C.
L'évolution de la masse volumique de l'électrolyte, mesurée et obtenue à partir du modèle prédictif, est illustrée sur la figure 4.
Le modèle prédictif ainsi que les mesures expérimentales confirment donc que l'autodécharge est accélérée sous l'effet de la température, puisqu'elle est environ 2,5 fois plus rapide qu'à 25 °C.

Simulation du potentiel électrique des électrodes négative et positive et de l'état de charge d'une la batterie à 45 °C.

La température du bain a ensuite été augmentée puis maintenue à 45 °C pendant 16 jours.
Comme cela est observé sur les figures 5a et 5b, le modèle prédictif reproduit fidèlement l'évolution du potentiel électrique de chacune des électrodes négative et positive.

De plus, la vitesse de décroissance du potentiel électrique de l'électrode positive est, comme à 25 °C et à 35 °C, environ quatre fois plus rapide que celle du potentiel électrique de l'électrode négative.

Le potentiel électrique de l'électrode positive décroît de 18 mV en 16 jours, soit d'environ 1,1 mV par jour, ce qui est environ 2,7 fois plus rapide qu'à 25 °C. De manière similaire, le potentiel électrique de l'électrode négative décroit de 4,3 mV en 16 jours, soit d'environ 0,27 mV par jour, ce qui est environ 4,5 fois plus rapide qu'à 25 °C.

L'évolution de la masse volumique de l'électrolyte, mesurée et obtenue à partir du modèle prédictif, est illustrée sur la figure 6.

Le modèle prédictif ainsi que les mesures expérimentales confirment donc que l'autodécharge est accélérée sous l'effet de la température, puisqu'elle est environ 4 fois plus rapide qu'à 25 °C.

Les figures 7a et 7b représentent de manière synthétique les figures la, 3a et 5a et 1b, 3b et 5b respectivement. Elle représentent l'évolution du potentiel de l'électrode positive et de l'électrode négative respectivement pour une autodécharge d'une durée de 49 jours à 25 °C suivie d'une durée de 34 jours à 35 °C et une durée de 16 jours à 45 °C. La figure 8 représente l'évolution de la masse volumique de l'électrolyte sur ces mêmes périodes de temps et plage de température.

Comme cela apparaît, la prise en compte de la température dans le modèle prédictif, dans l'équation (9) au moyen de la thermodynamique et dans l'équation (11) au moyen d'une formulation de type loi d'Arrhenius, permet de rendre compte précisément de l'évolution de l'état de charge en fonction de la température.

La mise en oeuvre du procédé selon cette variante de l'invention et de la méthode de gestion correspondante est particulièrement utile notamment pour les exploitants de batteries qui sont logées dans des pièces dont la température n'est pas régulée.

L'invention ne doit bien évidemment pas être réduite à l'exemple présenté à titre illustratif et non limitatif. En particulier, l'homme du métier sait modifier les équations (1) à (13) pour tenir compte de mécanismes additionnels ayant lieu dans la batterie au cours de l'autodécharge tout en restant dans la portée la plus large de l'invention. Il sait aussi adapter le modèle prédictif à d'autres références de batteries au plomb.

## Revendications

1. Procédé, mis en oeuvre par ordinateur, d'estimation de l'état de charge d'une batterie rechargeable au plomb électriquement au repos, la batterie comportant au moins une cellule électrochimique comportant un électrolyte acide, au moins une électrode négative en plomb et au moins une électrode positive en dioxyde de plomb immergées dans l'électrolyte, le procédé comportant la mise en oeuvre d'un modèle prédictif régi au moins par plusieurs équations différentielles pour estimer l'état de charge, le modèle prédictif étant configuré pour fournir une estimation de chacun des états de charge de l'au moins une électrode positive et de l'au moins une électrode négative.

2. Procédé selon la revendication 1, la batterie comportant une cellule électrochimique comportant une électrode négative et une électrode positive, l'état de charge de la batterie étant la plus petite valeur entre l'état de charge de l'électrode négative et l'état de charge de l'électrode positive.

3. Procédé selon la revendication 1, la batterie comportant plusieurs cellules électrochimiques, et l'état de charge de la batterie étant la plus petite valeur entre le plus petit état de charge parmi l'ensemble des électrodes négatives de la batterie et le plus petit état de charge parmi l'ensemble des électrodes positives de la batterie.

4. Procédé selon l'une quelconque des revendications précédentes, l'état de charge de l'électrode négative étant égal au rapport de la capacité électrique de l'électrode négative sur la capacité électrique à charge maximale de l'électrode négative, et l'état de charge de l'électrode positive étant égal au rapport de la capacité électrique de l'électrode positive sur la capacité électrique à charge maximale de l'électrode positive.

5. Procédé selon l'une quelconque des revendications précédentes, le modèle prédictif étant régi au moins par :

   - au moins une équation différentielle relative à l'électrode négative, qui détermine l'évolution temporelle d'au moins une grandeur physique caractéristique de l'état électrochimique de l'électrode négative,
   - au moins une équation différentielle relative à l'électrode positive, qui détermine l'évolution temporelle d'au moins une grandeur physique caractéristique de l'état électrochimique de l'électrode positive, et
   - au moins une équation différentielle relative à l'électrolyte, qui détermine l'évolution temporelle d'au moins une grandeur physique caractéristique de l'état électrochimique de l'électrolyte.

6. Procédé selon la revendication précédente, la grandeur physique caractéristique de l'électrode négative étant choisie

parmi le potentiel électrique de l'électrode négative, la capacité électrique de l'électrode négative, la quantité de sulfate de plomb électrodéposée à la surface de l'électrode négative, la quantité de plomb résiduelle à l'électrode négative.

**7.** Procédé selon l'une quelconque des revendications 5 et 6, la grandeur physique caractéristique de l'électrode positive étant choisie parmi le potentiel électrique de l'électrode positive, la capacité électrique de l'électrode positive, la quantité de sulfate de plomb électrodéposée à la surface de l'électrode positive, la quantité de plomb résiduelle à l'électrode positive.

**8.** Procédé selon l'une quelconque des revendications 5 à 7, la grandeur physique caractéristique de l'électrolyte étant choisie parmi le nombre de moles d'eau de l'électrolyte, le nombre de moles d'acide sulfurique de l'électrolyte, la densité de l'électrolyte, la molalité de l'électrolyte, la molarité de l'électrolyte.

**9.** Procédé selon l'une quelconque des revendications précédentes, les équations différentielles étant des équations différentielles ordinaires, en particulier du premier ordre, et/ou couplées entres elles.

**10.** Procédé selon l'une quelconque des revendications précédentes, le modèle prédictif étant dépendant de la température de l'électrolyte.

**11.** Procédé selon l'une quelconque des revendications précédentes, la batterie au plomb étant de type étanche.

**12.** Procédé selon l'une quelconque des revendications précédentes, comportant la détermination préalable des paramètres initiaux du modèle prédictif au moyen d'une batterie au plomb test qui est identique à la batterie au plomb dont l'état de charge est à estimer.

**13.** Procédé selon l'une quelconque des revendications précédentes, le modèle prédictif étant régi par les équations différentielles suivantes, assorties des relations suivantes :

$$\begin{cases} \dot{u}_{\mathrm{neg}} = -\dfrac{i_{\mathrm{Pb}}}{C_{\mathrm{dc,neg}}} - \dfrac{i_{\mathrm{H_2}}}{C_{\mathrm{dc,neg}}} \\ \dot{u}_{\mathrm{pos}} = -\dfrac{i_{\mathrm{PbO_2}}}{C_{\mathrm{dc,pos}}} - \dfrac{i_{\mathrm{O_2}}}{C_{\mathrm{dc,pos}}} \\ \dot{Q}_{\mathrm{neg}} = -\mathcal{A}_{\mathrm{neg}}\, i_{\mathrm{Pb}} \\ \dot{Q}_{\mathrm{pos}} = \mathcal{A}_{\mathrm{pos}}\, i_{\mathrm{PbO_2}} \\ \dot{n}_0 = -\dfrac{\mathcal{A}_{\mathrm{pos}}}{F}\, i_{\mathrm{PbO_2}} - \dfrac{\mathcal{A}_{\mathrm{pos}}}{2\,F}\, i_{\mathrm{O_2}} \\ \dot{n}_{\mathrm{A}} = \dfrac{\mathcal{A}_{\mathrm{pos}}}{2\,F}\, i_{\mathrm{PbO_2}} - \dfrac{\mathcal{A}_{\mathrm{neg}}}{2\,F}\, i_{\mathrm{Pb}} \end{cases}$$

dans lesquelles

- $u_{neg}$, $Q_{neg}$ et $A_{neg}$ étant respectivement le potentiel électrique, la capacité électrique et l'aire de la surface électroactive de l'électrode négative de la batterie,
- $u_{pos}$ et $Q_{pos}$ et $A_{pos}$ étant respectivement le potentiel électrique, la capacité électrique et l'aire de la surface électroactive de l'électrode positive de la batterie,
- $C_{dc,neg}$ et $C_{dc,pos}$ étant les capacitances de double couche constantes associées à l'électrode négative et l'électrode positive respectivement,
- $F$ est la constante de Faraday,
- $n_O$ et $n_A$ étant les moles d'eau et d'acide sulfurique respectivement,
- $i_{Pb}$ étant l'intensité du courant électrique associée à la réaction électrochimique suivante

$$\mathrm{Pb} + \mathrm{H_2SO_4} \rightleftharpoons \mathrm{PbSO_4} + 2\,\mathrm{H^+} + 2\,\mathrm{e^-}$$

- $i_{H2}$ étant l'intensité du courant électrique associée à la réaction électrochimique suivante

$$2\,\mathrm{H^+} + 2\,\mathrm{e^-} \rightleftharpoons \mathrm{H_2}$$

- $i_{O2}$ étant l'intensité du courant électrique associée à la réaction électrochimique suivante

$$\mathrm{H_2O} \rightleftharpoons \frac{1}{2}\,\mathrm{O_2} + 2\,\mathrm{H^+} + 2\,\mathrm{e^-}$$

- $i_{PbO2}$ étant l'intensité du courant électrique associée à la réaction électrochimique suivante

$$\mathrm{PbO_2} + \mathrm{H_2SO_4} + 2\,\mathrm{H^+} + 2\,\mathrm{e^-} \rightleftharpoons \mathrm{PbSO_4} + 2\,\mathrm{H_2O}$$

les courants électriques $i_k$, avec $k$ étant l'une quelconque des réactions électrochimiques d'indice $O_2$, H2, Pb et $PbO_2$ étant tels que

$$i_k = i_{0,k}\left\{\exp\left[(1-\alpha_k)\,\frac{n_k\,F\,\eta_k}{R\,T^\circ}\right] - \exp\left[-\alpha_k\frac{n_k\,F\,\eta_k}{R\,T^\circ}\right]\right\}$$

avec

- $R$ étant la constante des gaz parfaits,
- $n_k$ étant le nombre d'électrons transférés,
- $T°$ étant une température de référence prédéterminée, de préférence comprise entre 293 K et 298 K,
- $\alpha_k$ étant le facteur de symétrie de la réaction correspondante,
-

$$\eta_k = u_k - u_k^0$$

le potentiel d'équilibre $u_k^0$ étant tel que

$$u_k^0 = \frac{\Delta\bar{G}_k^0\,(T^\circ)}{n_k\,F} - (T - T^\circ)\,\frac{\Delta\bar{S}_k^0\,(T^\circ)}{n_k\,F} - (T - T^\circ)^2\,\frac{\Delta\bar{C}_{p,k}^0\,(T^\circ)}{2\,n_k\,F\,T}$$

$T$ étant la température de l'électrolyte, $\Delta\bar{G}_k^0$, $\Delta\bar{S}_k^0$ et $\Delta\bar{C}_{p,k}^0$ étant respectivement l'énergie libre de Gibbs molaire, l'entropie molaire et la capacité calorifique molaire de la réaction avec $k$ parmi les indices $O_2$, H2, Pb et $PbO_2$, et étant déterminés à partir de la molalité $m_A$ qui est définie comme

$$m_A = 55.5\,\frac{n_A}{n_0}$$

la densité de courant d'échange $i_{0,k}$ étant définie par l'équation

$$i_{0,k} = n_k\,F\,\left(\prod_i a_{i,O}^{s_{i,O}}\right)^{1-\alpha_k}\left(\prod_j a_{j,R}^{s_{j,R}}\right)^{\alpha_k} k_{0,k}\exp\left(-\frac{\Delta\bar{G}_{\ddagger,k}}{RT}\right)$$

dans laquelle
- $a_i$ est l'activité de chaque espèce $i$ impliquée dans la réaction $k$,
- $k_{0,k}$ est la constante cinétique de la réaction électrochimique $k$,
- $\Delta\bar{G}_{\ddagger,k}$ est l'énergie libre de Gibbs molaire de l'état de transition,
- les termes O et R sont relatifs à l'activité d'oxydation et de réduction respectivement,
- $s_{i,O}$ et $s_{j,R}$ sont des paramètres,

la tension électrique globale de la batterie $u_{batt}$ étant exprimée par l'équation,

$$u_{\mathrm{batt}} = N_{\mathrm{cell}}\,u_{\mathrm{cell}} = N_{\mathrm{cell}}\left(u_{\mathrm{pos}} - u_{\mathrm{neg}}\right)$$

$N_{cell} \geq 1$ étant le nombre de cellules électrochimiques connectées électriquement en série dans la batterie, l'état de charge de la batterie $SOC_{batt}$ étant la plus faible valeur entre l'état de charge de l'électrode négative $SOC_{neg}$ et l'état de charge de l'électrode positive $SOC_{pos}$,

$$SOC_{\mathrm{batt}} = \min\left(SOC_{\mathrm{pos}}, SOC_{\mathrm{neg}}\right) = \min\left(\frac{Q_{\mathrm{pos}}}{Q_{\mathrm{pos,max}}}, \frac{Q_{\mathrm{neg}}}{Q_{\mathrm{neg,max}}}\right)$$

$Q_{neg,max}$ étant la capacité maximale de l'électrode négative, $Q_{pos,max}$ étant la capacité maximale de l'électrode positive.

**14.** Méthode de gestion de la charge d'au moins une batterie rechargeable au plomb électriquement au repos, la méthode comportant la mise en œuvre du procédé selon l'une quelconque des revendications précédentes pour déterminer l'état de charge de la batterie au plomb, et lorsque l'état de charge de la batterie au plomb est inférieur ou égal à une valeur minimale d'état de charge, l'alimentation électrique de la batterie pour en augmenter l'état de charge.

**15.** Méthode de gestion selon la revendication précédente, la batterie étant un organe d'un équipement d'alimentation électrique de secours d'une installation choisie parmi un centre de données, ou « data center » en anglais, un hôpital, une centrale nucléaire et un central téléphonique et/ou internet.

[Fig 1a]

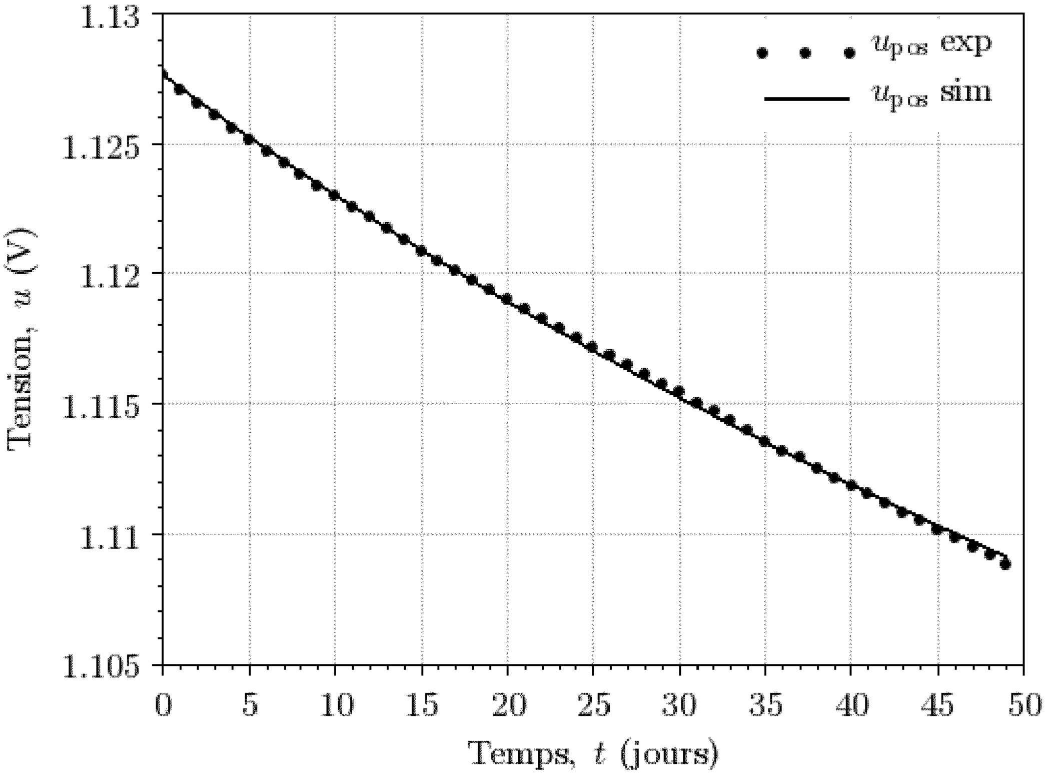

1.13
1.125
1.12
1.115
1.11
1.105
0
5
10
15
20
25
30
35
40
45
50
Tension, $u$ (V)
Temps, $t$ (jours)
$u_{pos}$ exp
$u_{pos}$ sim


[Fig 1b]

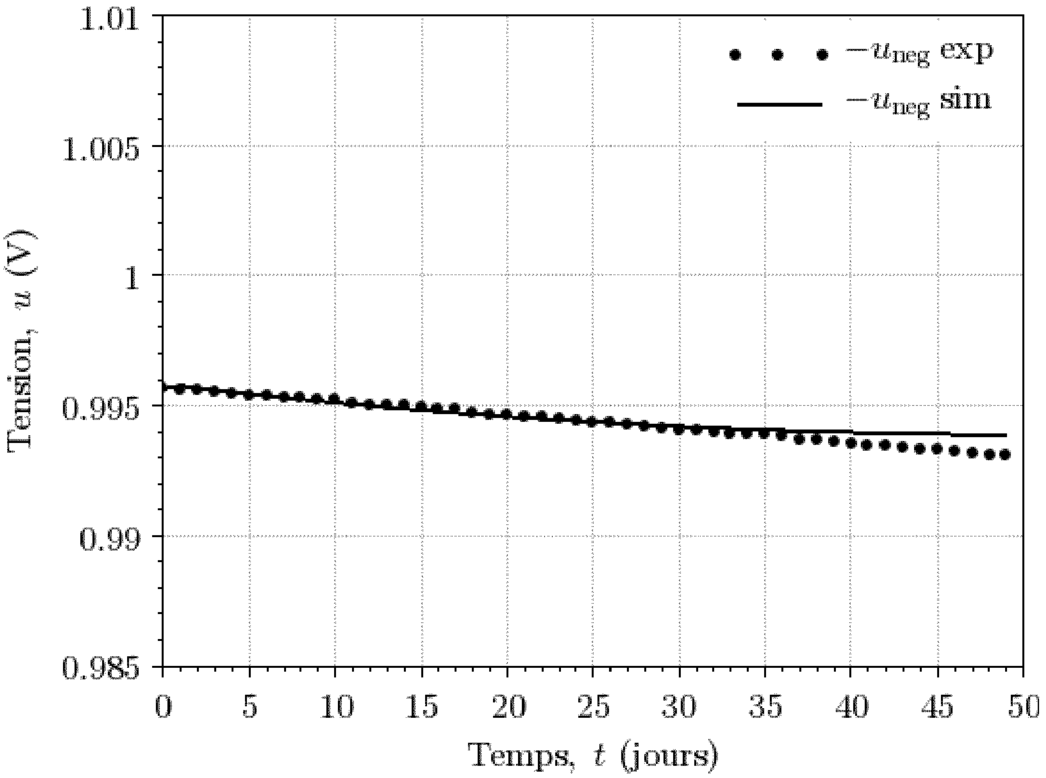

1.01
1.005
1
0.995
0.99
0.985
0
5
10
15
20
25
30
35
40
45
50
Tension, $u$ (V)
Temps, $t$ (jours)
$-u_{neg}$ exp
$-u_{neg}$ sim

[Fig 2]

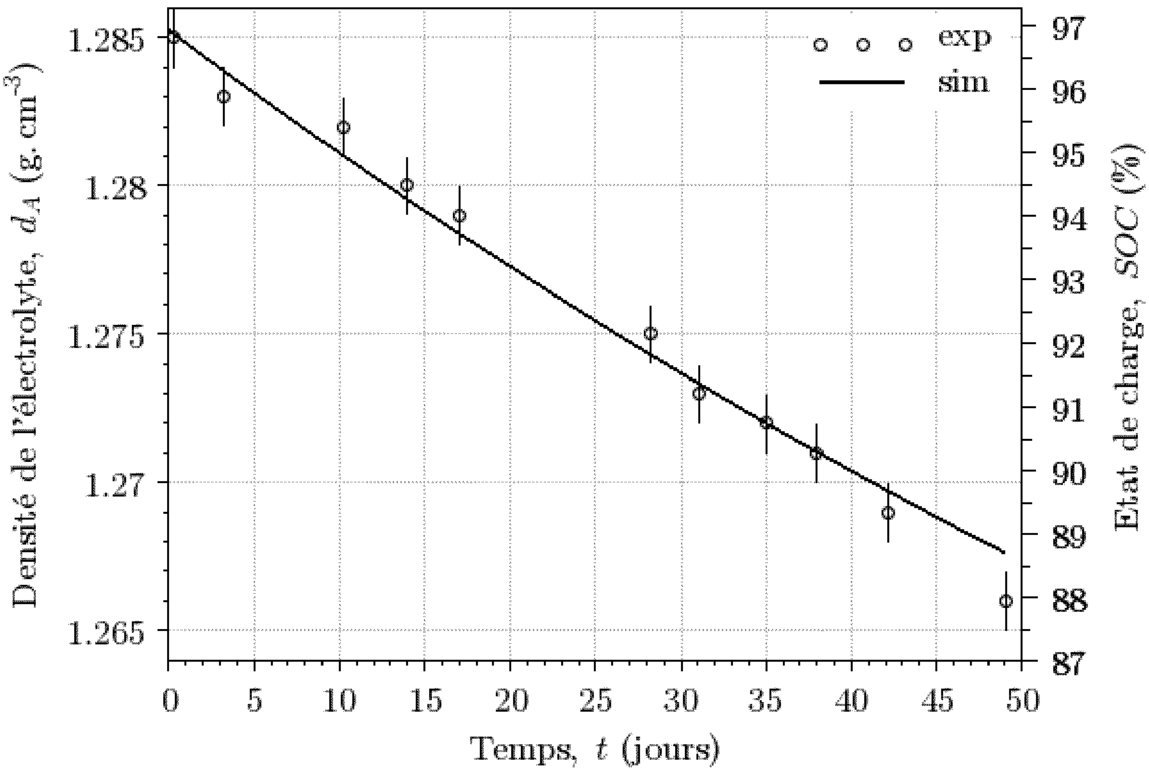
exp
sim
Densité de l'électrolyte, $d_A$ (g. cm$^{-3}$)
Etat de charge, SOC (%)
Temps, $t$ (jours)
1.285
1.28
1.275
1.27
1.265
97
96
95
94
93
92
91
90
89
88
87
0
5
10
15
20
25
30
35
40
45
50

[Fig 3a]

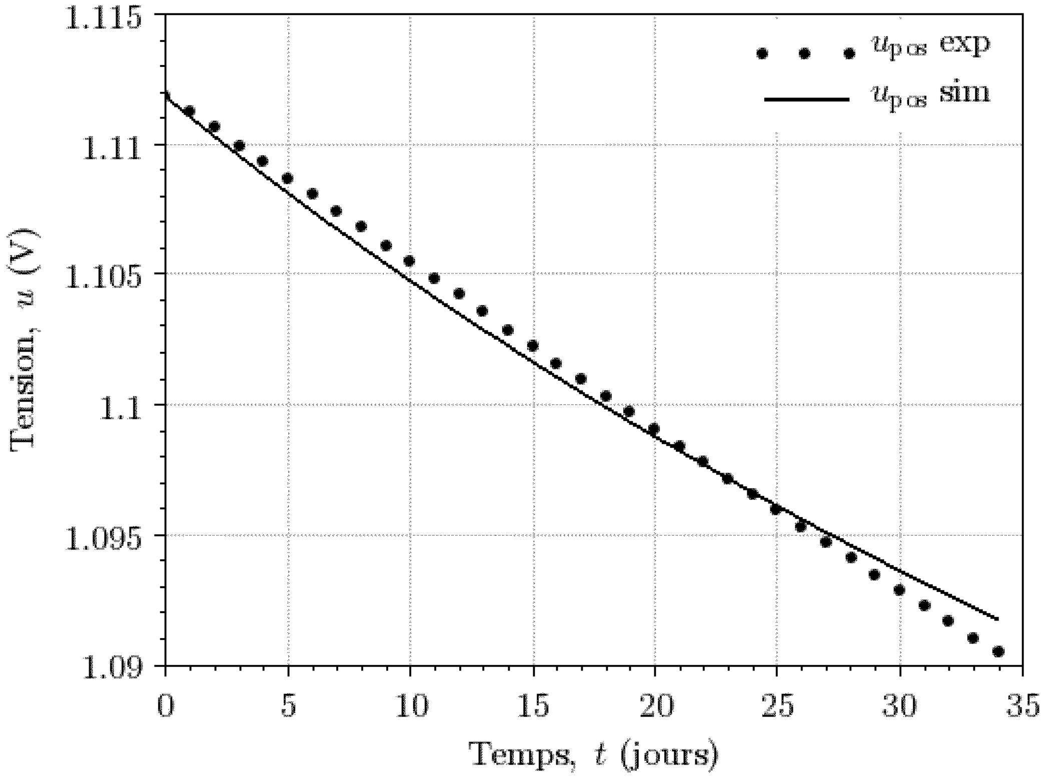
$u_{pos}$ exp
$u_{pos}$ sim
Tension, $u$ (V)
Temps, $t$ (jours)
1.115
1.11
1.105
1.1
1.095
1.09
0
5
10
15
20
25
30
35

[Fig 3b]

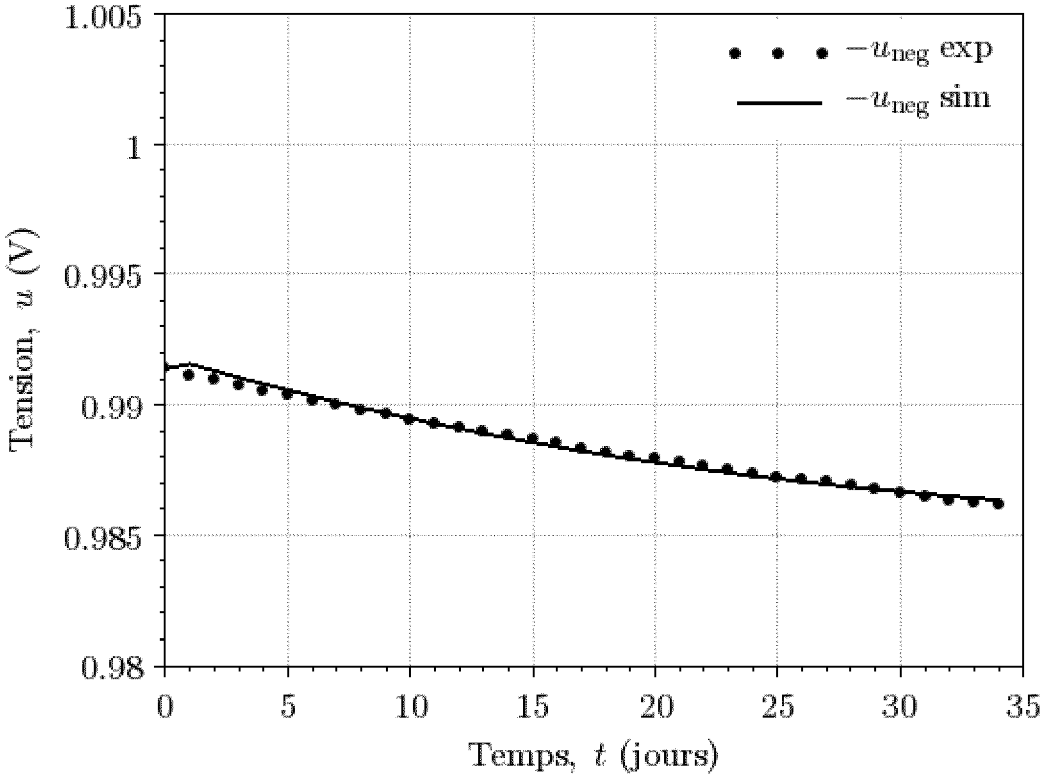
$-u_{neg}$ exp
$-u_{neg}$ sim
Tension, $u$ (V)
1.005
1
0.995
0.99
0.985
0.98
0
5
10
15
20
25
30
35
Temps, $t$ (jours)

[Fig 4]

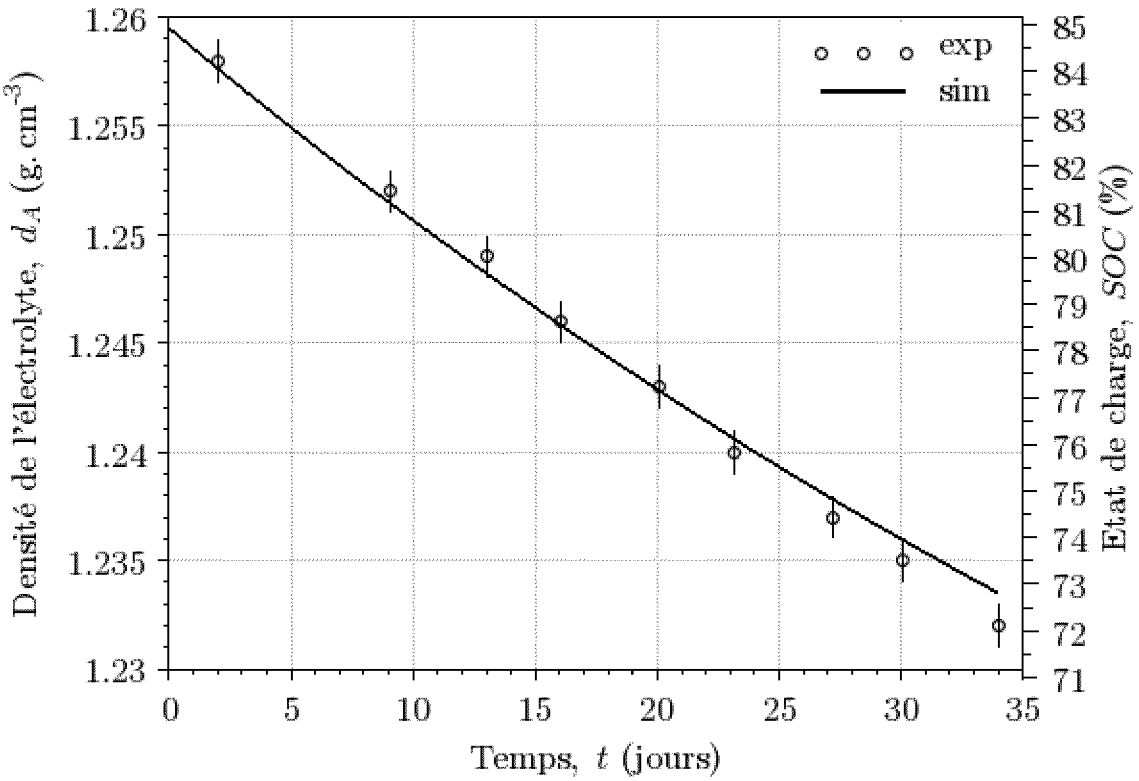
exp
sim
Densité de l'électrolyte, $d_A$ (g.cm$^{-3}$)
Etat de charge, $SOC$ (%)
1.26
1.255
1.25
1.245
1.24
1.235
1.23
85
84
83
82
81
80
79
78
77
76
75
74
73
72
71
0
5
10
15
20
25
30
35
Temps, $t$ (jours)

[Fig 5a]

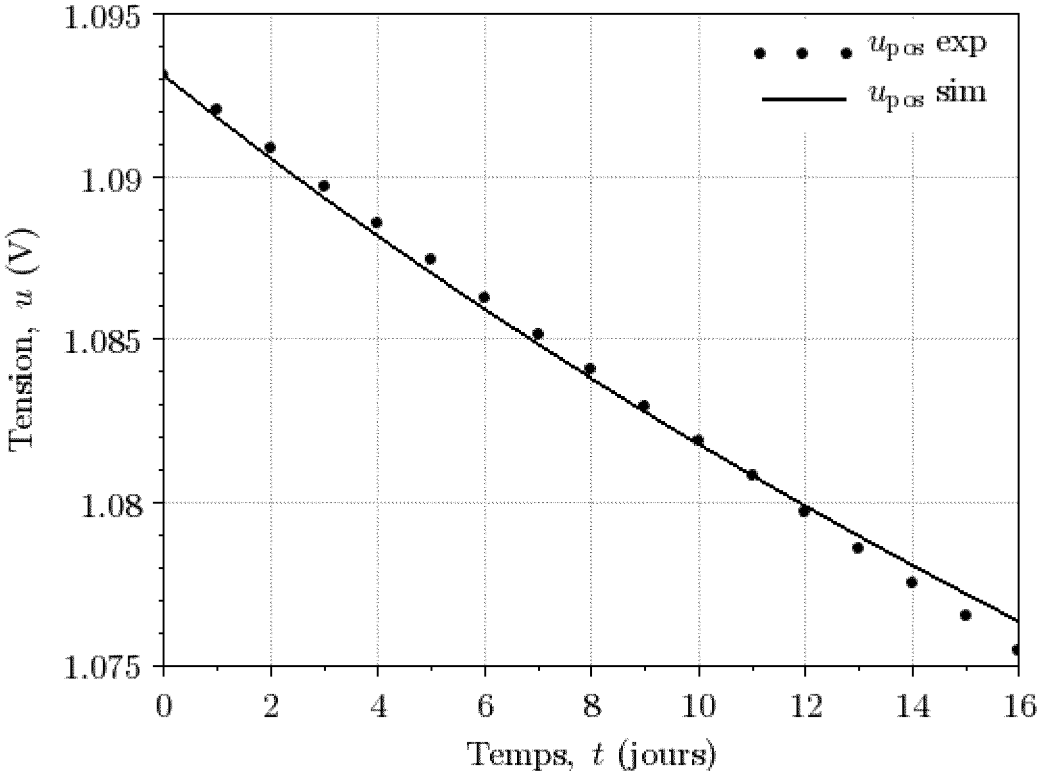
1.095
1.09
1.085
1.08
1.075
Tension, $u$ (V)
0
2
4
6
8
10
12
14
16
Temps, $t$ (jours)
$u_{pos}$ exp
$u_{pos}$ sim

[Fig 5b]

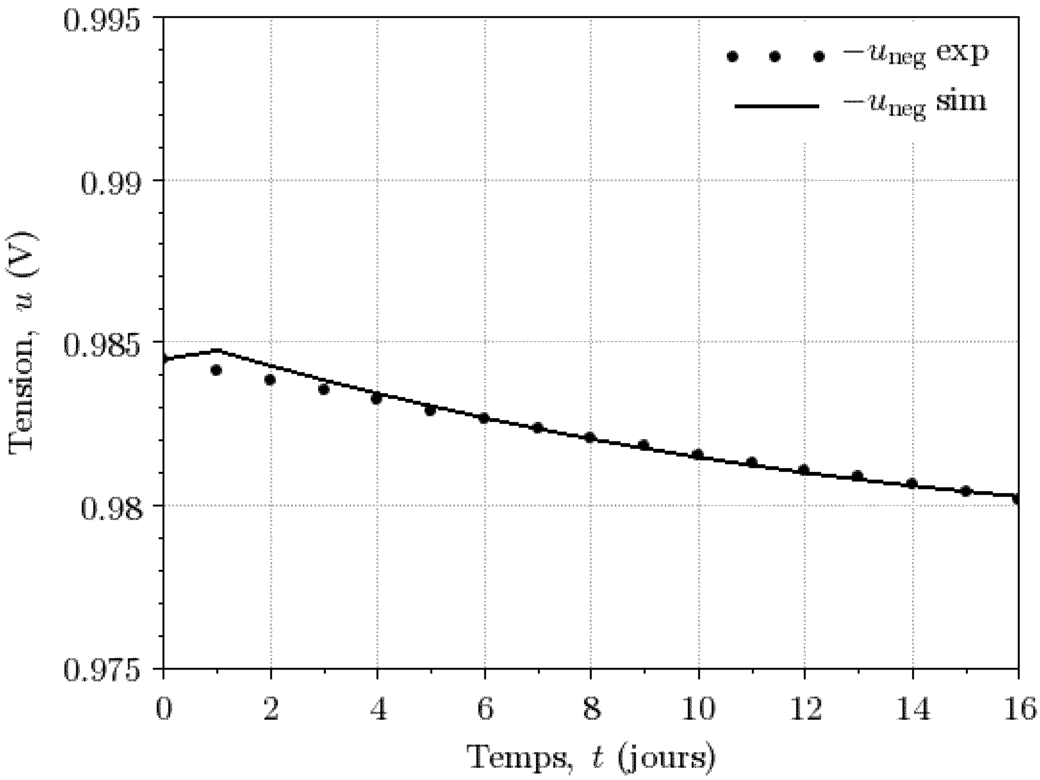
0.995
0.99
0.985
0.98
0.975
Tension, $u$ (V)
0
2
4
6
8
10
12
14
16
Temps, $t$ (jours)
$-u_{neg}$ exp
$-u_{neg}$ sim

[Fig 6]

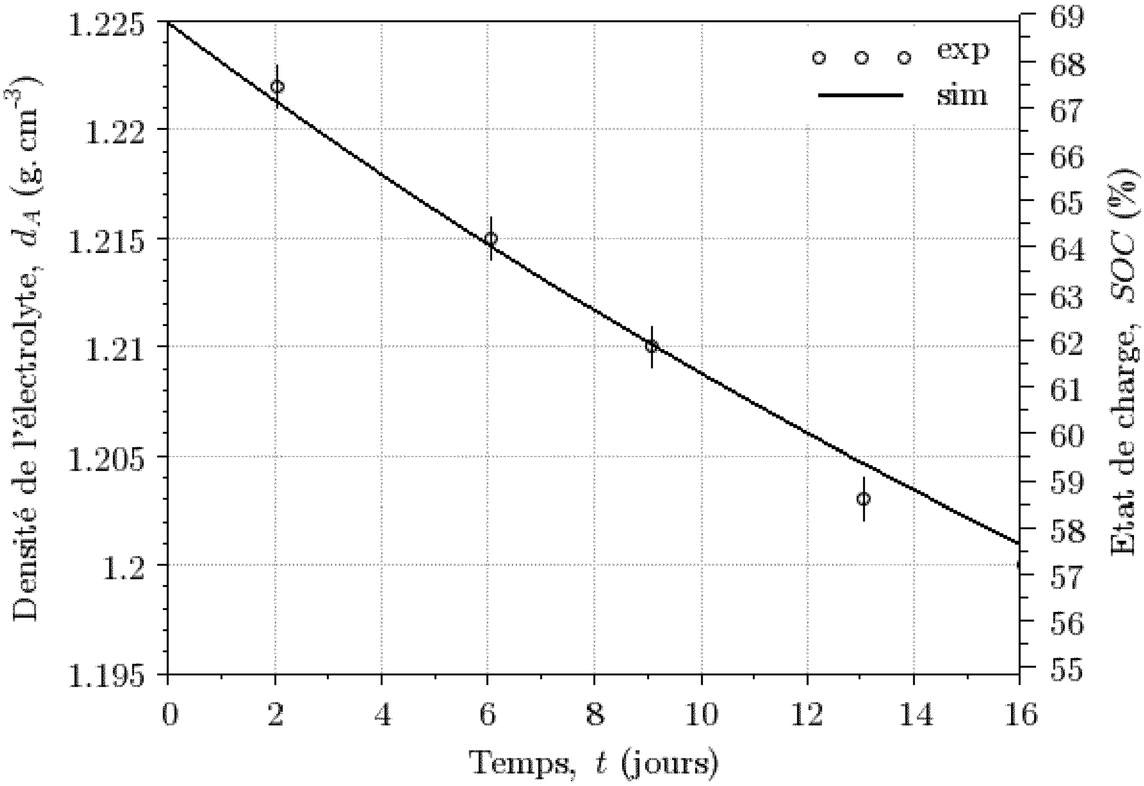
1.225
1.22
1.215
1.21
1.205
1.2
1.195
Densité de l'électrolyte, $d_A$ (g.cm$^{-3}$)
69
68
67
66
65
64
63
62
61
60
59
58
57
56
55
Etat de charge, $SOC$ (%)
exp
sim
0
2
4
6
8
10
12
14
16
Temps, $t$ (jours)

[Fig 7a]

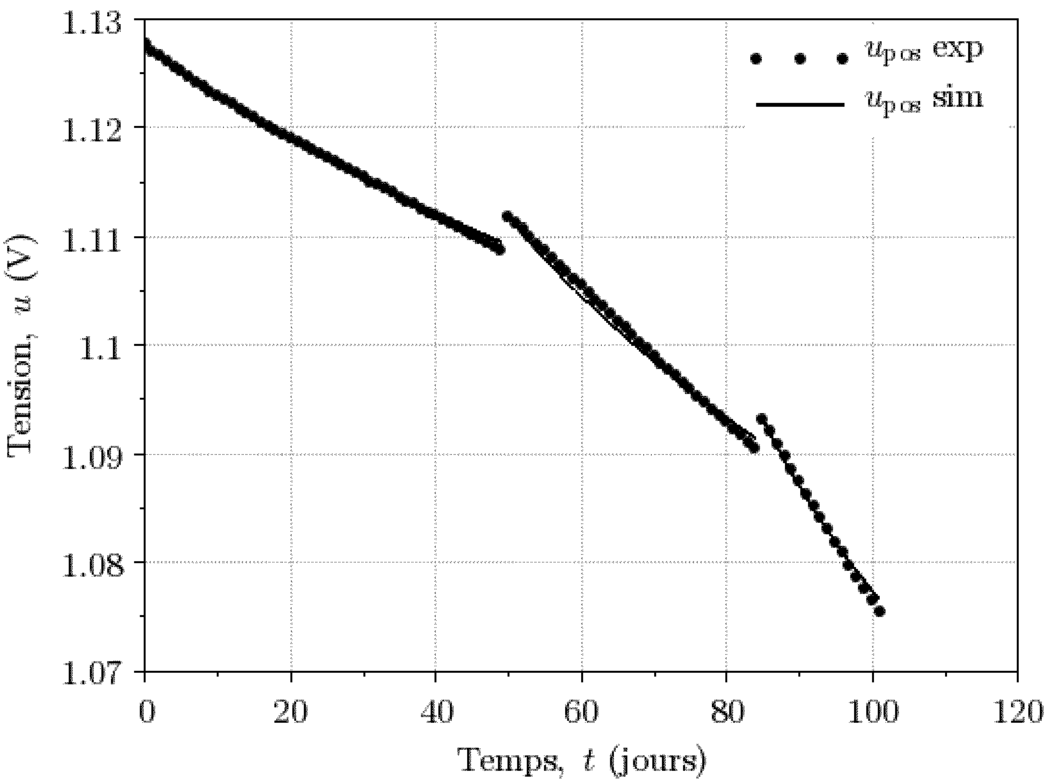
1.13
1.12
1.11
1.1
1.09
1.08
1.07
Tension, $u$ (V)
$u_{pos}$ exp
$u_{pos}$ sim
0
20
40
60
80
100
120
Temps, $t$ (jours)

[Fig 7b]

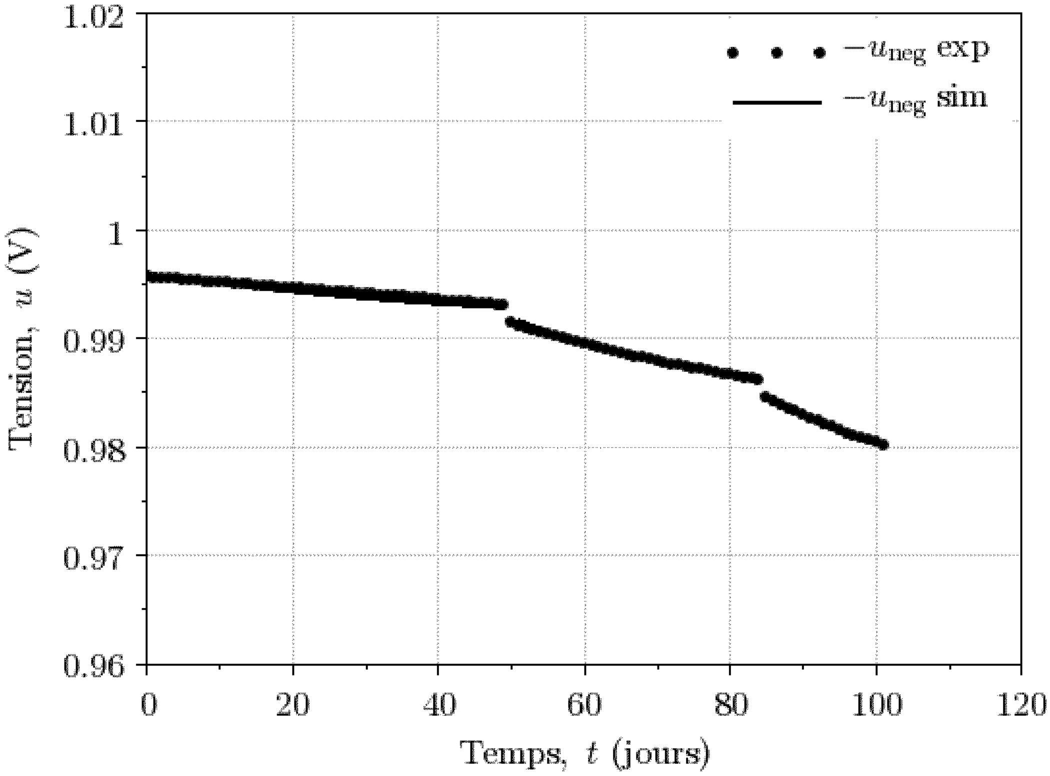
1.02
1.01
1
0.99
0.98
0.97
0.96
Tension, $u$ (V)
$-u_{neg}$ exp
$-u_{neg}$ sim
0
20
40
60
80
100
120
Temps, $t$ (jours)

[Fig 8]

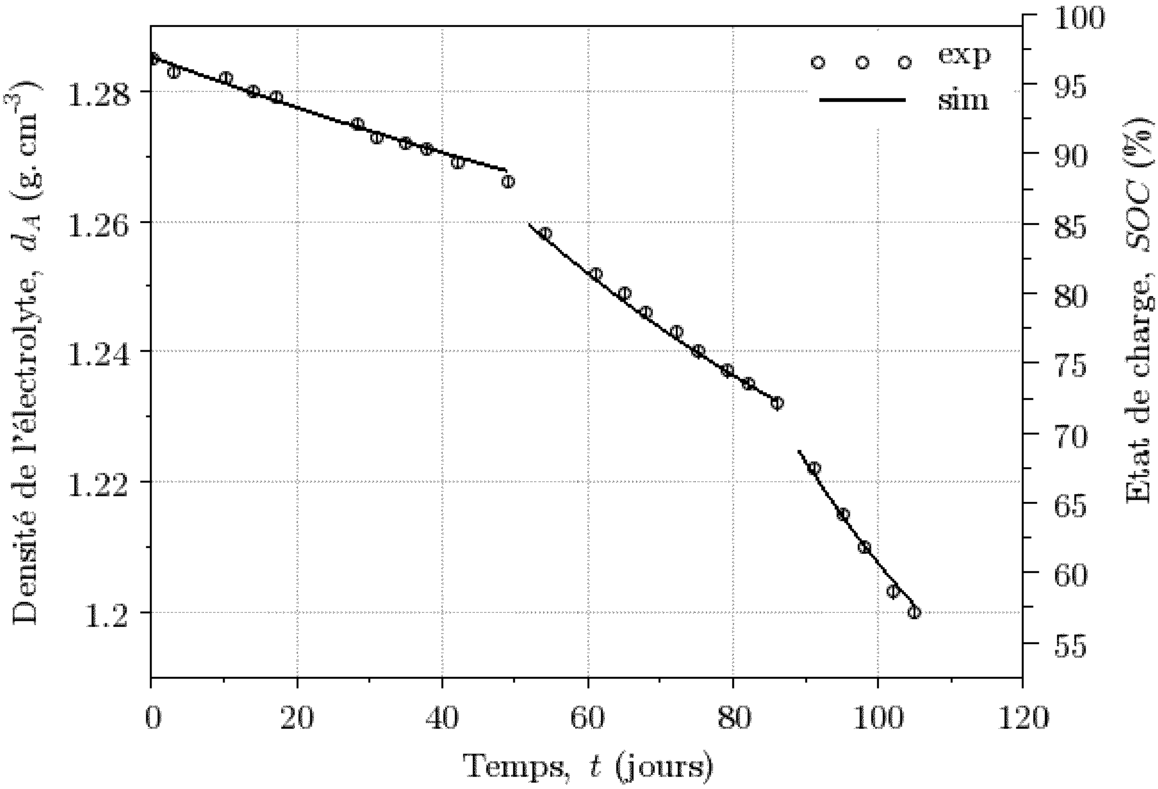
1.28
1.26
1.24
1.22
1.2
Densité de l'électrolyte, $d_A$ (g. cm$^{-3}$)
100
95
90
85
80
75
70
65
60
55
Etat de charge, $SOC$ (%)
exp
sim
0
20
40
60
80
100
120
Temps, $t$ (jours)

Europäisches Patentamt
European Patent Office
Office européen des brevets

# RAPPORT DE RECHERCHE EUROPEENNE

Numéro de la demande
EP 22 21 2878

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | US 2021/247454 A1 (SARFERT CHRISTEL [DE] ET AL) 12 août 2021 (2021-08-12)<br>* abrégé *<br>* alinéas [0001] - [0014], [0021], [0031] - [0037] *<br>* revendications 1,2,4,5 *<br>* figure 2 *<br>----- | 1-15 | INV.<br>G01R31/367<br>G01R31/379<br>G01R31/387<br>G01R31/382 |
| Y | MADUSANKA S A U A ET AL: "Improving the Performance of Lead Acid Batteries using Nano-Technology",<br>2019 MORATUWA ENGINEERING RESEARCH CONFERENCE (MERCON), IEEE,<br>3 juillet 2019 (2019-07-03), pages 589-593, XP033608759,<br>DOI: 10.1109/MERCON.2019.8818890<br>ISBN: 978-1-7281-3631-8<br>[extrait le 2019-08-28]<br>* abrégé *<br>* figure 5 *<br>* Chapitres I et 2: I. Introduction, II. Simulation *<br>----- | 1-15 | |
| | | | DOMAINES TECHNIQUES RECHERCHES (IPC) |
| Y | SEAMAN ADEN ET AL: "A survey of mathematics-based equivalent-circuit and electrochemical battery models for hybrid and electric vehicle simulation",<br>JOURNAL OF POWER SOURCES, ELSEVIER, AMSTERDAM, NL,<br>vol. 256, 14 février 2014 (2014-02-14), pages 410-423, XP028661717,<br>ISSN: 0378-7753, DOI: 10.1016/J.JPOWSOUR.2014.01.057<br>* le document en entier *<br>-----<br>-/-- | 1-9,13 | G01R<br>H01M |

Le présent rapport a été établi pour toutes les revendications

1

| Lieu de la recherche | Date d'achèvement de la recherche | Examinateur |
|---|---|---|
| Munich | 6 avril 2023 | Poizat, Christophe |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.........................................................................
& : membre de la même famille, document correspondant

EPO FORM 1503 03.82 (P04C02)

page 1 de 2

Europäisches Patentamt
European Patent Office
Office européen des brevets

# RAPPORT DE RECHERCHE EUROPEENNE

Numéro de la demande
EP 22 21 2878

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | EP 2 293 091 A2 (IFP ENERGIES NOUVELLES [FR]) 9 mars 2011 (2011-03-09)<br>* Le document en entier, en particulier [0040], [0089], [0095] *<br>----- | 1-10,13 | |
| A | TAESIC KIM ET AL: "A Hybrid Battery Model Capable of Capturing Dynamic Circuit Characteristics and Nonlinear Capacity Effects",<br>IEEE TRANSACTIONS ON ENERGY CONVERSION, IEEE SERVICE CENTER, PISCATAWAY, NJ, US,<br>vol. 26, no. 4,<br>1 décembre 2011 (2011-12-01), pages 1172-1180, XP011369832,<br>ISSN: 0885-8969, DOI: 10.1109/TEC.2011.2167014<br>* dernier alinéa *<br>----- | 1,5-8,13 | |
| A | US 2012/078552 A1 (MINGANT REMY [FR] ET AL) 29 mars 2012 (2012-03-29)<br>* abrégé *<br>* alinéas [0001], [0031] *<br>----- | 1,5-8,13 | DOMAINES TECHNIQUES RECHERCHES (IPC) |

Le présent rapport a été établi pour toutes les revendications

1

| Lieu de la recherche | Date d'achèvement de la recherche | Examinateur |
|---|---|---|
| Munich | 6 avril 2023 | Poizat, Christophe |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

## ANNEXE AU RAPPORT DE RECHERCHE EUROPEENNE RELATIF A LA DEMANDE DE BREVET EUROPEEN NO.

EP 22 21 2878

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

06-04-2023

| Document brevet cité au rapport de recherche | Date de publication | Membre(s) de la famille de brevet(s) | Date de publication |
|---|---|---|---|
| US 2021247454 A1 | 12-08-2021 | CN 113253112 A | 13-08-2021 |
| | | DE 102020201506 A1 | 12-08-2021 |
| | | US 2021247454 A1 | 12-08-2021 |
| EP 2293091 A2 | 09-03-2011 | EP 2293091 A2 | 09-03-2011 |
| | | FR 2949566 A1 | 04-03-2011 |
| US 2012078552 A1 | 29-03-2012 | EP 2434304 A1 | 28-03-2012 |
| | | FR 2965360 A1 | 30-03-2012 |
| | | JP 2012073256 A | 12-04-2012 |
| | | US 2012078552 A1 | 29-03-2012 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- RU 2138886 C1
- JP H0850925 B
- RU 2218635 C2
- US 10036779 B2

### Littérature non-brevet citée dans la description

- **W. TIEDEMANN ; J. NEWMAN.** Double-Layer Capacity Determination of Porous Electrodes. *J. Electrochem. Soc.,* 1975, vol. 122, 70, https://robots.iopscience.iop.org/article/10.1149/1.2134161/meta
- **D. WAGMAN ; W. H. EVANS ; V. B. PARKER ; R. H. SCHUMM ; I. HALOW ; S. M. BAILEY ; K. L. CHURNEY ; R. L. NUTTALL.** The NBS Tables of Chemical Thermodynamic Properties. *J. Phys. Chem. Ref. Data,* 1982, vol. 11 (2
- **H. BODE.** Lead-Acid Batteries. John Wiley & Sons, Inc, 1977